# EUROPEAN PATENT APPLICATION

(11) **EP 2 887 406 A1**
(43) Date of publication of application: **24.06.2015**
(21) Application number: 13199448.5
(22) Date of filing: 23.12.2013
(51) Int. Cl.: H01L 31/075, H01L 31/18

(54) **Semiconductor device and method for fabricating said semiconductor device**

(71) Applicant: CSEM Centre Suisse d'Electronique et de Microtechnique SA - Recherche et Développement, 2002 Neuchâtel (CH)
(72) Inventor: Domine, Didier, 2052 Bienne (CH); Bailat, Julien, 2503 Bienne (CH); Scolan, Emmanuel, 2000 Neuchâtel (CH); Blondiaux, Nicolas, 2206 Les Geneveys-sur-Coffrane (CH)
(74) Representative: GLN SA

(57) **Abstract**

The present invention relates to a semiconductor device comprising a substrate; a thin-film multi-layer structure, arranged on said substrate, said thin-film multi-layer structure comprising several layers defining a junction therebetween, said junction being selected from a group comprising a p-n junction, a n-p junction, a p-i-n junction, an n-i-p junction, or a combination thereof; an outer layer, arranged on said thin-film multi-layer structure, said outer layer being arranged opposite to said substrate; at least one passivation layer. Said passivation layer is arranged between two layers of said thin-film multi-layer structure.

The present invention relates also to a method for fabricating such semiconductor device.

## Description

### 1. Field of the invention

The present invention relates to a method allowing a decrease of the charge carrier recombination rate at an interface within an electronic device or an optoelectronic device made of thin-film silicon and its alloys. It covers the implementation of a sheet of fixed electric charges, negative or positive, within the device made of thin-film silicon and its alloys, and located at the interface between a region of p or n type, respectively, and an intrinsic or non-intentionally doped (denoted here after i) region of the device. It relates also to the arrangement used to obtain this sheet of fixed electric charges within the device made of thin-film silicon and its alloys, this while providing the transport of free charge carriers of opposite sign as the one of the fixed charges, towards the region of p type or n type.

### 2. State of the Art

The principles of passivation of an interface by a film with a low defect density and a fixed electric charge are well known in the art and described in [Hoex et al. J. Appl. Phys. 104, 113703 (2008)], [A. Richter et al. Phys. Status Solidi RRL 5, No. 5-6 (2011)] and [Vermang et al., Solar Energy Materials & Solar Cells 117, 505-511 (2013)] for the case of a passivating film made of aluminum oxide (Al2O3) and its application in devices made of crystalline silicon, multi-crystalline silicon or Cu(In, Ga)Se2) thin-films. On the contrary, the implementation of those principles within a device made of thin-film silicon and its alloys, particularly at the interface between a p type region and an intrinsic (i) region of the device, seem new to us.

On the one hand it is indeed well known that for a semiconductor of p type, e.g. silicon denoted hereafter <p> Si, the fixed negative charge produced by the deposition of an Al2O3 film at the surface of the semiconductor, before the deposition of e.g. an aluminum contact, causes an interface passivation. The resulting <p> Si/Al2O3 interface is of better electronic quality than <p> Si/Al interfaces. This is because of the reduced minority charge carrier's concentration (electrons) at the surface of the semiconductor which, in turn, decreases the recombination rate of the minority carriers at interfacial defect states close to the silicon surface. In the patent application [US2009/0283139 (A1)] it already has been proposed to passivate the surface of photovoltaic devices made of one or more p-n, p-i-n or n-i-p junctions of amorphous or microcrystalline silicon with a film, e.g. Al2O3, deposited on the upper surface of the p-n, pi-n, or n-i-p structure. Likewise, in the patent application [EP2077584 (A2)] it has been proposed to passivate one or the other, or the two surfaces of a photovoltaic device constituted by a p-n junction possibly made of a plurality of materials (silicon and its alloys, CdTe, Cu(In, Ga)Se2), this using a double film formed of (1) an oxide of the photovoltaic material and (2) a metal oxide containing a negative fixed charge. On the contrary, in the present invention we take into account the fact that electronic and optoelectronic devices with a p-i-n structure made of thin-film silicon involve an ambipolar transport. As the minority carriers are immediately lost by recombination events in thin-film silicon doped layers, it is not anymore the purpose to repeal minority carriers from the surface of a p type semiconductor (or n type) but to repeal, within the i layer, the electrons from the p/i interface (and/or the holes from the i/n interface), this while providing the transport of the holes through the passivating film towards the p layer (and/or the electrons towards the n layer).

On the other hand, in the case of surface passivation of crystalline or multi-crystalline silicon by an insulating film, e.g. an Al2O3 film, the collection of majority carriers is provided by who is skilled in the art with openings within the insulating film. The width of those openings is typically of the order of 100 microns and they can be spaced by several hundreds of microns up to several millimeters, this because of the large diffusion length of free carriers in crystalline and multi-crystalline silicon. In the case of thin-film silicon however, taking into account the short diffusion length of free carriers in an intrinsic film (in the order of 100 nm to some microns), up to now it has seemed to who is skilled in the art impossible to provide a sufficient transport via openings through a passivating and insulating film of Al2O3 while preserving the repealing effect on the electrons. It is one aim of this invention to consider the concept of local openings at the scale of one hundred nanometers recently published in [Vermang et al., Solar Energy Materials & Solar Cells 117, 505-511 (2013)] for thin-film Cu(In, Ga))Se2 solar cells and to recognize that this concept opens an unexpected perspective for the implementation of the passivation scheme using a film with a low defect density and fixed electric charges in devices made of thin-film silicon and its alloys.

### 3. Summary of the invention

An object of the invention is to provide a mean to decrease the free carrier recombination rate at a given interface considered within an electronic or an optoelectronic device made of thin-film silicon and its alloys. This is achieved by the insertion of an interstitial film or by an interface treatment between two thin-film silicon layers within the device. This interstitial film or this interface treatment involves a low interface defect density and a fixed electric charge, negative or positive, repealing the free charge carriers of opposite sign as the one allowed being transported through the film. The resulting decrease of the free charge carrier recombination rate decreases the inverse saturation current density (Js) in the device. If this device made of thin-film silicon and its alloys is a photovoltaic solar cell, an increase of the open-circuit voltage follows. For a given photo-generated current density, therefore for a given total thickness of absorbers, this allows an increase in the energy conversion efficiency of the photovoltaic solar cell.

### 4. Definitions

A thin-film multilayer is defined as a stack of layers having a total thickness between 50 nm and 8000 nm, preferably between 150 nm and 5000 nm. The preferred materials of said thin-film multilayer stack are Si and its alloys, said alloys being preferably, but not limited to Si:C:H or Si:Ge:H. Said materials may be in the amorphous, nanocrystalline, or microcrystalline phase.

The outer layer is defined as a layer arranged on the thin-film multilayer and comprises at least a front-contact layer or a back-contact layer. Said outer layer may be opaque our transparent.

The intermediate layer is defined as a layer arranged on the substrate, and comprises at least a front-contact layer or a back-contact layer. Said intermediate layer may be opaque our transparent.

Said interstitial film is also defined as a passivation layer.

A p-n junction may be also a stack of p-n junctions.

An n-p junction may be also a stack of n-p junctions.

A p-i-n junction may also be a stack of p-i-n junction or a stack of p-i-n and/or n-p or p-n junction.

An n-i-p junction may also be a stack of n-i-p junction or a stack of p-i-n and/or n-p or p-n junctions.

Traversing holes are defined as apertures through said passivation layer, from the side to the substrate to the side of the outer layer of said passivation layer. Said traversing holes may have a substantially cylindrical shape or may have a curved shape. Different traversing holes may be connected, inside said passivation layer, by additional holes. Said additional holes may be holes arranged in the plane of said passivation layer.

### 5. Description of the invention

The present invention will be described in more detail below. It is understood that the various embodiments, preferences and ranges as provided/disclosed in this specification may be combined at will. Further, depending of the specific embodiment, selected definitions, embodiments or ranges may not apply.

Given a substrate on which a multi-layer structure is deposited, the top layer being a thin-film silicon layer, or one of its alloys, in amorphous, nanocrystalline or microcrystalline phase, and doped in such a way to present a p type character (or a n type character according to another embodiment), one embodiment of the present invention consists in depositing on this top layer an interstitial film with a low defect density and producing a sheet of fixed electric charges with opposite sign as the type of transport admitted by the top thin-film silicon layer, then to deposit on this interstitial film a thin-film silicon layer, or one of its alloys, intrinsic, or lightly doped, or doped in such a way to present a character with a type of the same sign as the sign of the sheet of fixed electric charges produced by the deposition of the interstitial film.

Given a substrate on which a multi-layer structure is deposited, the top layer being a thin-film silicon layer, or one of its alloys, in amorphous, nanocrystalline or microcrystalline phase, intrinsic or lightly doped, another embodiment of the present invention consists in depositing on this top layer an interstitial film with a low defect density and producing a sheet of fixed negative charges (or of fixed positive charges according to another embodiment), then to deposit on this interstitial film a thin-film silicon layer, or one of its alloys, doped in such a way to present a character with a type of the opposite sign as the sign of the sheet of fixed electric charges produced by the deposition of the interstitial film.

It will be obvious to who is skilled in the art that the two paragraphs above summarize all the configurations for the passivation with a field effect of each of the six interfaces represented in the following structures: p-n, n-p, p-i-n, n-i-p.

The interstitial film is made of a number of atomic monolayers, between 1 and 50, preferably between 1 and 10 ; and lead to a low interface defect density, typically less than 2·10¹² eV⁻¹ cm⁻²; and a fixed positive or negative charge density between 2·10¹¹ et 2·10¹³, preferably greater than 2·10¹² units of electronic charge per square centimeter.

According to the prior art, in order to increase the fixed charge density and therefore in order to improve the field effect passivation, any embodiment of the invention can include, during the device fabrication, a step of thermal annealing under controlled atmosphere, this either immediately after deposition of the interstitial film, either after having deposited one or more subsequent layer(s).

If needed, i.e. if a transport using tunneling is not sufficient, local openings at the nanometer scale will be provided in the interstitial film. A method proposed in the present invention to provide openings at the nanometer scale is to produce a masking, before the deposition of the interstitial film, this masking being produced by plasma, essentially of silane and hydrogen, in powder regime. Possibly, this plasma can be the one used for the deposition of the thin-film silicon layer, or one of its alloys, on which the interstitial film will be deposited. The step of masking is followed, in analogy to the technique described in [Vermang et al., Solar Energy Materials & Solar Cells 117, 505-511 (2013)], by the deposition of the interstitial film and then by an opening step, for instance using sonication, dry-ice jet cleaning, or mechanical wiping. The lateral size and spacing of the openings, defined in the plane of the interstitial film, are comprised between 10 nm and 1000 nm, preferably between 50 nm and 200 nm.

### 6. Examples

To further illustrate the invention, the following examples are provided, with no intention to limit the scope of the invention.

6.1 Integration of an Al2O3 interstitial film deposited by ALD or by MVD between the p and i layers of a photovoltaic solar cell of structure p-i-n made of hydrogenated amorphous silicon (a-Si:H).

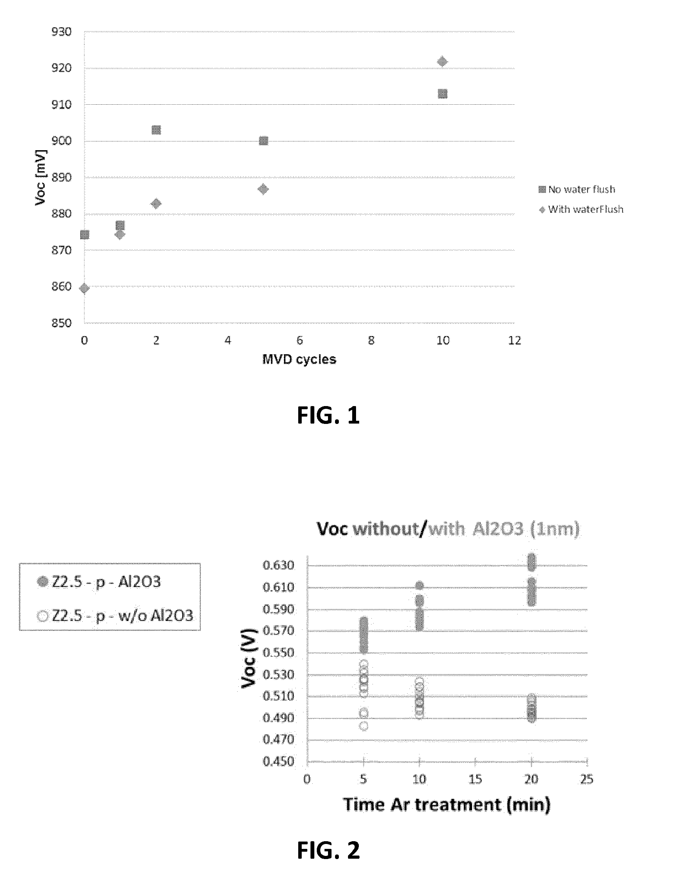

Figure 1 shows the open-circuit voltage (Voc) of thin-film photovoltaic solar cells made of amorphous silicon with respect to the number of MVD cycles used in the deposition of the Al2O3 interstitial film between the <p> a-Si:C:H layer and the <i> a-Si:C:H layer of the device. Results with and without a vapor water flush exposition before the MVD deposition are presented. Note that in this example the Al2O3 film does not have any opening; in consequence the poor transport of positive charge carriers towards the <p> a-Si:C:H layer induces a decrease of the conversion efficiency of the solar cell.

6.2 Integration of an Al2O3 interstitial film deposited by ALD or by MVD between the p and i layers of a photovoltaic solar cell of structure p-i-n made of hydrogenated microcrystalline or nanocrystalline silicon (µc-Si:H or nc-Si:H).

Figure 2 shows the open-circuit voltage (Voc) of thin-film photovoltaic solar cells made of microcrystalline silicon with respect to the duration of an argon plasma treatment applied at the front ZnO contact layer. Results with/without an Al2O3 interstitial film deposited in 10 MVD cycles between the <p> µc-Si:H layer and the <i> µc-Si:H layer of the device are presented. Note that in this example the Al2O3 film does not have any opening; in consequence the poor transport of positive charge carriers towards the <p> µc-Si:H layer induces a decrease of the conversion efficiency of the solar cell.

### 7. Drawings

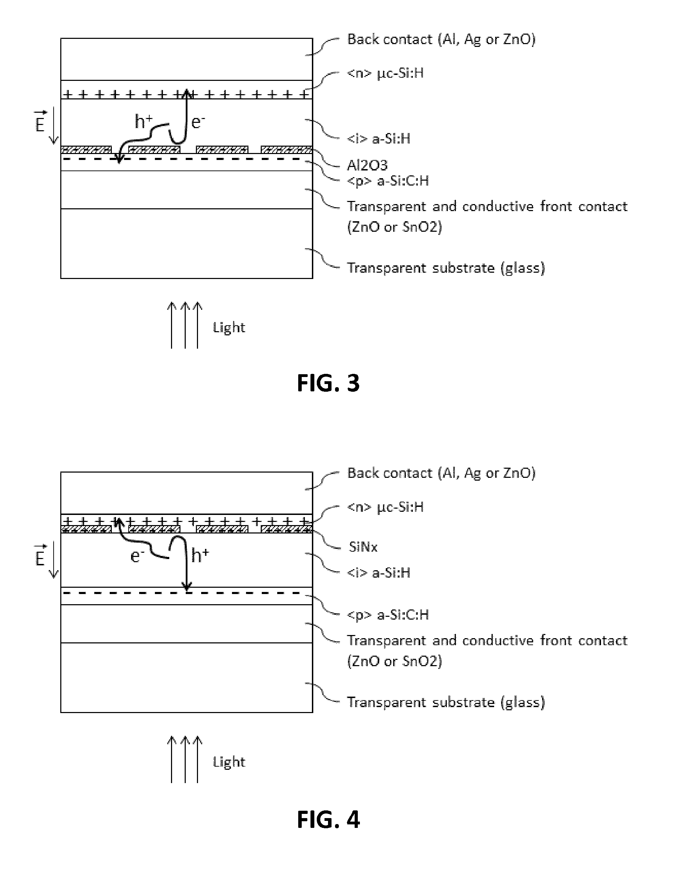

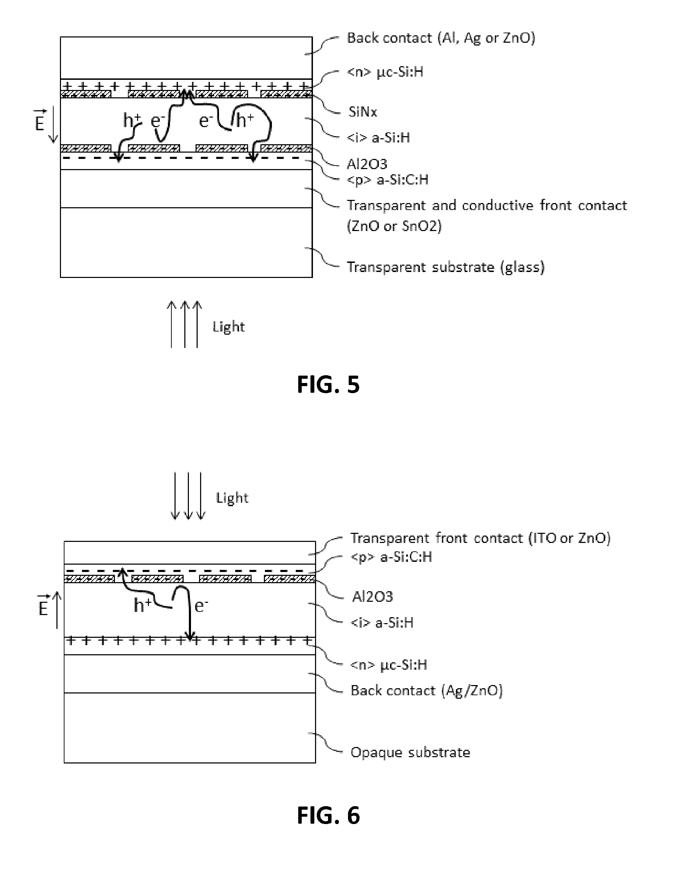

The use of the present invention to the case of a thin-film photovoltaic solar cell made of amorphous silicon is illustrated in the six following drawings. The alternatives for a solar cell of structure p-i-n are given in Figures 3 to 5; the alternatives for a solar cell of structure n-i-p are given in figures 6 to 8.

In Figure 3 a free electron-hole pair (e⁻-h⁺) is photo-generated within the intrinsic absorber (<i> a-Si:H layer) of a p-i-n solar cell deposited on a transparent substrate. The hole and the electron are under the influence of a random thermal movement (which on average is the cause of the diffusion currents of holes and electrons) and of the built-in electric field (E) produced by the ionized donors and acceptors of the <n> µc-Si:H and <p> a-Si:C:H layers, respectively (E is the cause of the drift currents of holes and electrons). In Fig. 3 it is suggested that the free electron under consideration is first driven more effectively by the thermal movement towards the p side of the device. Thanks to the low defect density of the Al2O3 interstitial film and to an additional local field-effect produced by the additional negative fixed charges associated to its deposition, it is expected that the probability of recombination of this free electron at the i/p interface is decreased. The free hole under consideration is also driven both by a random thermal movement and by the built-in electric field E. Thanks to the fact that openings are provided in the Al2O3 interstitial film at a nanometer scale, the free hole under consideration finally find its path by diffusion towards the <p> a-Si:C:H layer, this despite the fact that the built-in electric field is oriented in a direction normal to the plane of the device.

Figure 3 shows an example of passivation at the p/i interface with additional negative fixed charges produced by the deposition of an Al2O3 interstitial film within a thin-film photovoltaic device of structure pi-n made of amorphous silicon. In this example of embodiment, the interstitial film has openings at the nanometer scale.

Figure 4 shows an example of passivation at the i/n interface with additional positive fixed charges produced by the deposition of a SiNx interstitial film within a thin-film photovoltaic device of structure p-i-n made of amorphous silicon. In this example of embodiment, the interstitial film has openings at the nanometer scale.

Figure 5 shows an example of passivation at the p/i and i/n interfaces with additional negative fixed charges produced by the deposition of an Al2O3 interstitial film and with additional positive fixed charges produced by the deposition of a SiNx interstitial film, respectively, within a thin-film photovoltaic device of structure p-i-n made of amorphous silicon. In this example of embodiment, the two interstitial films have openings at the nanometer scale.

Figure 6 shows an example of passivation at the i/p interface with additional negative fixed charges produced by the deposition of an Al2O3 interstitial film within a thin-film photovoltaic device of structure n-i-p made of amorphous silicon. In this example of embodiment, the interstitial film has openings at the nanometer scale.

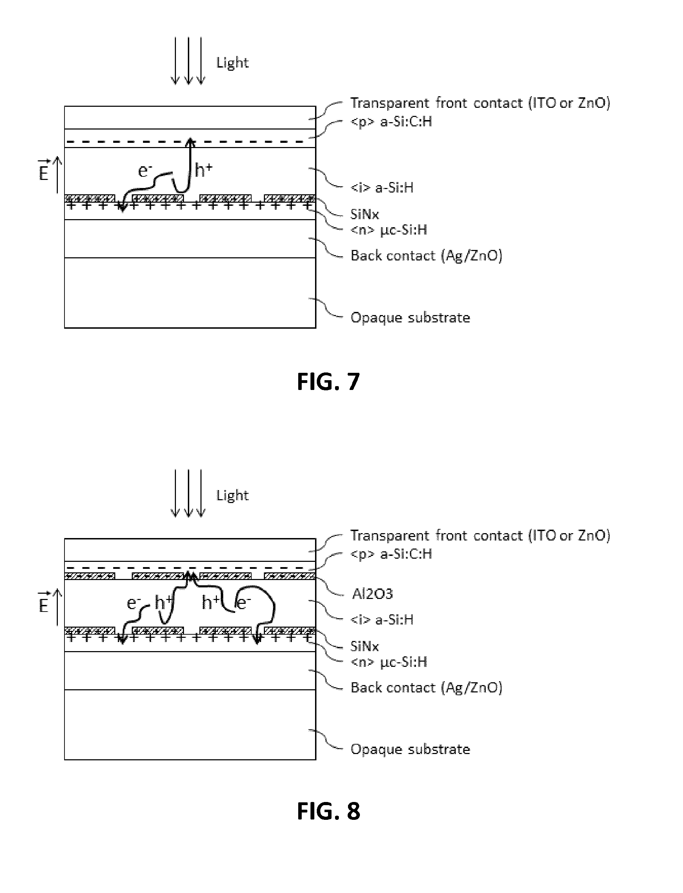

Figure 7shows an example of passivation at the n/i interface with additional positive fixed charges produced by the deposition of a SiNx interstitial film within a thin-film photovoltaic device of structure n-i-p made of amorphous silicon. In this example of embodiment, the interstitial film has openings at the nanometer scale.

Figure 8 shows an example of passivation at the i/p and n/i interfaces with additional negative fixed charges produced by the deposition of an Al2O3 interstitial film and with additional positive fixed charges produced by the deposition of a SiNx interstitial film, respectively, within a thin-film photovoltaic device of structure n-i-p made of amorphous silicon. In this example of embodiment, the two interstitial films have openings at the nanometer scale.

### Summary

Interstitial film or interface treatment within an electronic or an optoelectronic device made of thin-film silicon and its alloys. This interstitial film or this interface treatment involves :
■ a low interface defect density and
■ a fixed charge, negative or positive,
   - allowing to decrease the free carrier recombination rate at a given interface considered within the device.

Said interstitial film where the film is made of a number of atomic monolayers, between 1 and 50, preferably between 1 and 10 ; and lead to a low interface defect density, typically less than 2·10¹² eV⁻¹ cm⁻² ; and a fixed positive or negative charge density between 2·10¹¹ et 2·10¹³, preferably greater than 2·10¹² units of electronic charge per square centimeter.

Said interstitial film or said interface treatment involving a fixed negative charge allowing to decrease the recombination rate of free carriers of p type (holes) at an interface having a side of p type within a device made of thin-film silicon and its alloys.

Said interstitial film or said interface treatment involving a fixed positive charge allowing to decrease the recombination rate of free carriers of n type (electrons) at an interface having a side of n type within a device made of thin-film silicon and its alloys.

Said interstitial film or said interface treatment implemented within an optoelectronic device made of thin-film silicon and its alloys, with a p-i-n structure.

Said interstitial film or said interface treatment where the said optoelectronic device with a p-in structure is a photovoltaic solar cell.

Said interstitial film or said interface treatment located between the p type region and the intrinsic (i) region of the said device made of thin-film silicon and its alloys.

Said interstitial film where the film is produced by a process of type ALD (atomic layer deposition) or MVD (molecular vapor deposition).

Said interstitial film where the film is made of aluminum oxide (Al2O3), silicon oxide (SiOx), silicon nitride (SiNx) or silicon oxynitride (SiOxNy) ; or of a stack of these materials.

Method to provide local openings at the nanometer scale in the said interstitial film and consisting, before the deposition of the interstitial film, to produce a masking produced by plasma, essentially of silane and hydrogen, in powder regime. The step of masking is followed, in analogy to the technique described in [Vermang et al., Solar Energy Materials & Solar Cells 117, 505-511 (2013)], by the deposition of the interstitial film as above and then by an opening step, for instance using sonication, dry-ice jet cleaning, or mechanical wiping.

### 8. Advantage

Increase of the open-circuit voltage (Voc) of solar cells integrated in thin-film silicon photovoltaic modules (simple-junction or multi-junction; on rigid or flexible substrate, opaque or transparent). For a given photo-generated current density, therefore a given total thickness of absorbers, this allows an increase in the energy conversion efficiency of the photovoltaic module.

### 9. References

Hoex et al. J. Appl. Phys. 104, 113703 (2008),
A. Richter et al. Phys. Status Solidi RRL 5, No. 5-6 (2011),
Vermang et al., Solar Energy Materials & Solar Cells 117, 505-511 (2013),
EP2077584 (A2) - 2009-07-08 - Passivation layer structure of solar cell and fabricating method thereof. SUN WEN-CHING [TW]; CHEN CHIEN-HSUN [TW]; LAN CHUNG-WEN [TW]; HUANG CHIEN-RONG [TW],
US2009283139 (A1) - 2009-11-19 - Semiconductor structure combination for thin-film solar cell and manufacture thereof. CHEN MIIN-JANG [TW]; HSU WEN-CHING [TW]; HO SUZ-HUA [TW].

| | |
|---|---|
| | |
| Technical interest | Increase of the open-circuit voltage (Voc) |
| Commercial Interest | **Thin-film silicon photovoltaic module** |
| Interest to improve protection in this field | **The use of Al2O3 is a very hot-topic in several photovoltaic technologies.** |

## Claims

1. A semiconductor device comprising:
- a substrate;
- a thin-film multi-layer structure, arranged on said substrate, said thin-film multi-layer structure comprising several layers defining a junction therebetween, said junction being selected from a group comprising a p-n junction, a n-p junction, a p-i-n junction, an n-i-p junction, or a combination thereof;
- an outer layer, arranged on said thin-film multi-layer structure, said outer layer being arranged opposite to said substrate;
- at least one passivation layer,
**characterized in that** said passivation layer is arranged between two layers of said thin-film multi-layer structure.

2. The semiconductor device according to claim 1, **characterized in that** said passivation layer is a continuous layer.

3. The semiconductor device according to claim 1 or 2, **characterized in that** said passivation layer comprises traversing holes.

4. The semiconductor device according to claim 3, **characterized in that** the lateral size and the spacing of said holes, defined in the plane of said passivation layer, are comprised between 1 nm and 10000 nm, preferably between 10 nm and 1000 nm, more preferably between 50 nm and 200 nm.

5. The semiconductor device according to any one of claims 1 to 4, **characterized in that** said passivation layer has a thickness comprised between 0.1 nm and 10 nm, preferably between 0.2 nm and 5 nm.

6. The semiconductor device according to one of claims 1 to 5, **characterized in that** at least one of said passivation layers is made of a material chosen among a group comprising AlOₓ, SiN_{y}, SiOₓN_{y}, SiOₓ, or a combination thereof, with x comprised between 0.2 and 2, and y comprised between 0 and 1.5.

7. The semiconductor device according to one of claims 1 to 6, **characterized in that** said passivation layer has a negatively or positively charged surface, said charged surface having a charge density comprised between 2. 10¹¹ and 2.10¹³ units of electronic charge per square centimeter, and preferably comprised between 2.10¹² and 2.10¹³ units of electronic charge per square centimeter.

8. The semiconductor device according to one of claims 1 to 7, **characterized in that** said passivation layer has a low midgap interface defect density comprised between 2.10¹⁰ eV⁻¹cm⁻² and 2.10¹² eV⁻¹cm, preferably between 2.10¹⁰ eV⁻¹cm⁻² and 2.10¹¹ eV⁻¹cm.

9. The semiconductor device according to one of claims 1 to 8, **characterized in that** said thin-film multi-layer structure comprises at least a doped p-layer, an i-layer which is a non intentionally doped layer, and a doped n-layer.

10. The semiconductor device according to claim 9, **characterized in that** said passivation layer is arranged between the doped p-layer and the i-layer.

11. The semiconductor device according to claim 9 or 10, **characterized in that** said passivation layer is arranged between the doped n-layer and the i-layer.

12. The semiconductor device according to one of claims 9 to 11, **characterized in that** the doped p-layer, the i-layer and the doped n-layer define a p-i-n junction.

13. The semiconductor device according to one of claims 9 to 11, **characterized in that** the doped p-layer, the i-layer and the doped n-layer define a n-i-p junction.

14. The semiconductor device according to one of claims 1 to 12, **characterized in that** said thin-film multi-layer comprises at least two p-i-n junctions.

15. The semiconductor device according to one of claims 1 to 11 and 13, **characterized in that** said thin-film multi-layer comprises at least two n-i-p junctions.

16. The semiconductor device according to one of claims 14 or 15, **characterized in that** at least two said passivation layers are arranged in said thin-film multilayer structure.

17. The semiconductor device according to any one of claims 1 to16, **characterized in that** said semiconductor device is a photovoltaic module.

18. The semiconductor device according to claim 17, **characterized in that** the outer layer of said photovoltaic module comprises at least a contact layer, said outer layer may be transparent or opaque.

19. The semiconductor device according to claim 18, **characterized in that** an intermediate layer is arranged between said substrate and said thin-film multi-layer, said intermediate layer comprising at least a contact layer.

20. The semiconductor device according to claim 18 or to claim 19, **characterized in that** said substrate is transparent or opaque.

21. The semiconductor device according to any one of claims 1 to 16, **characterized in that** said semiconductor device is an opto-electronic device.

22. The semiconductor device according to any one of claims 1 to 16, **characterized in that** said semiconductor device is a diode.

23. The semiconductor device according to any one of claims 1 to 16, **characterized in that** said semiconductor device is a transistor.

24. A method for fabricating a semiconductor device according to any one of claims 3 to 20, comprising the steps of:
- providing a substrate
- depositing preferably an intermediate layer
- depositing at least one layer of said thin-film multi-layer structure, preferably by an atomic layer deposition process, or a molecular vapor deposition process,
- realizing a masking produced by a plasma, preferably a plasma produced from a mixture of silane or a hydrogen,
- depositing a passivation layer,
- forming holes in the passivation layer preferably by sonication, or dry-ice cleaning, or mechanical wiping,
- depositing additional layers of said thin-film multi-layer
- depositing an outerlayer.
